# EUROPEAN PATENT APPLICATION

(11) **EP 2 584 571 A1**
(43) Date of publication of application: **24.04.2013**
(21) Application number: 11814485.6
(22) Date of filing: 26.07.2011
(51) Int. Cl.: H01F 17/00, H01F 17/04, H01F 41/04

(54) **ELECTRONIC CIRCUIT CHIP AND METHOD OF MANUFACTURING ELECTRONIC CIRCUIT CHIP**

(30) Priority: 05.08.2010 JP 2010176472
(71) Applicant: Fujikura, Ltd., Tokyo 135-8512 (JP)
(72) Inventor: KIKUKAWA Naohiro, Chiba 285-8550 (JP)
(74) Representative: Cabinet Plasseraud
(86) International application number: PCT/JP2011/066914
(87) International publication number: WO 2012/017857

(57) **Abstract**

An electric circuit chip includes: a substrate made of glass or a semiconductor; and a circuit which is disposed in an inside of the substrate, has a first end portion and a second end portion exposed at specific surfaces of the substrate, and includes a spiral inductor.

## Description

### TECHNICAL FIELD

The present invention relates to an electric circuit chip having an internal circuit which includes an inductor and a method of manufacturing the electric circuit chip.
Priority is claimed on Japanese Patent Application No. 2010-176472, filed August 5, 2010, the content of which is incorporated herein by reference.

### BACKGROUND ART

In the related art, there has been a wired circuit board having a solenoid coil-like wire in the circuit board.
In this wired circuit board, a wire which functions as an inductor is formed by laminating a layer having a wire that extends in parallel with the major surface of the circuit board and a layer having a wire that extends in a perpendicular direction to the major surface of the circuit board (refer to the following Patent Document 1).

In the case of a composite circuit board in which a plurality of layers is laminated, the layers are likely to be poorly joined or to be separated at the boundary.
In addition, since the layers are connected by combining linear wires, the connection portions form a discontinuously curved wire shape.
Since an electric current concentrates at the curved portions, the transmission loss of high-frequency signals and the like is likely to occur.
As a result, there is a problem of a poor generation efficiency of a magnetic field when an electric current is applied to a solenoid coil.
In addition, in a case in which the circuit board is deformed, since stress concentrates at the curved portions, the wire and the circuit board are likely to be separated.

### PRIOR ART DOCUMENTS

### PATENT DOCUMENTS

[Patent Document 1] Japanese Unexamined Patent Application, First Publication No. 2003-100517

### DISCLOSURE OF INVENTION

### PROBLEMS TO BE SOLVED BY INVENTION

The invention has been made in consideration of the above circumstances, and an object of the invention is to provide an electric circuit chip having an inductor which can reduce the poor joining or peeling of circuits, the transmission loss of high-frequency signals and the like, and is excellent in terms of mechanical strength, and a method of manufacturing the electric circuit chip.

### MEANS FOR SOLVING THE PROBLEMS

(1) An electric circuit chip according to a first aspect of the invention includes a substrate made of glass or a semiconductor; and a circuit which is disposed in the inside of the substrate, has a first end portion and a second end portion exposed respectively at specific surfaces of the substrate, and includes a spiral inductor.
(2) In the electric circuit chip according to the above (1), external electrode terminals may be provided at the first end portion and the second end portion.
(3) In the electric circuit chip according to the above (1) or (2), the inductor may have a spiral shape that follows a virtual column, elliptical column, or circular ring.
(4) In the electric circuit chip according to any one of the above (1) to (3), the inductor may be constituted by a continuous curve.
(5) In the electric circuit chip according to any one of the above (1) to (4), a core made of a magnetic body may be provided in a space surrounded by the inductor.
(6) In the electric circuit chip according to any one of the above (1) to (5), the first end portion and the second end portion may be provided on the same surface of the substrate.
(7) In the electric circuit chip according to any one of the above (1) to (5), the substrate may employ a configuration in which a first surface and a second surface which is located on the opposite side of the first surface are provided, the first end portion is provided on the first surface, and the second end portion is provided on the second surface.
(8) A method of manufacturing an electric circuit chip according to a second aspect of the invention includes irradiating the inside of a substrate made of glass or a semiconductor with laser light and scanning a focal point at which the laser light is collected, thereby forming spiral modified regions (Process A); carrying out an etching treatment on the substrate in which the modified regions are formed, and removing the modified regions, thereby forming spiral micropores (Process B); and filling the micropores with a conductor or forming a film of the conductor thereon (Process C).
(9) In the method of manufacturing an electric circuit chip according to the above (8), when the modified regions are formed (Process A), the modified regions may be formed in an area in which a core is formed.

### EFFECTS OF THE INVENTION

According to the electric circuit chip according to the first aspect of the invention, a circuit including an inductor is formed by filling micropores, which are disposed in a single-layer substrate made of glass or a semiconductor, with a conductor or forming a film of the conductor thereon.
In addition, even in a case in which mechanical stress is applied to the substrate, the substrate is not disassembled (peeling which occurs in a substrate constituted by multiple layers does not occur), and the circuit including an inductor is not easily short-circuited.
That is, the electric circuit chip according to the first aspect of the invention is excellent in terms of the structural strength.
Furthermore, since the substrate is made of glass or a semiconductor, the heat resistance is far superior compared to a substrate made of a resin or the like.
In addition, in a case in which the inductor has a spiral shape that follows a column, elliptical column, or circular ring virtually installed in the core region and is constituted by a continuous curve, it is possible to reduce short-circuiting caused by poor joining or peeling of wires (circuit) which configure the inductor.
Furthermore, since the inductor does not include a curved portion that forms a sharp angle, it is possible to reduce transmission loss.
As a result, the inductor is excellent in terms of magnetic field generation efficiency.

According to the method of manufacturing an electric circuit chip according to the second aspect of the invention, it is possible to freely form the modified regions that form the circuit by irradiating the circuit board (substrate) with laser.
Therefore, it is possible to form an inductor having a seam-free continuous curve.

### BRIEF DESCRIPTION OF THE DRAWINGS

FIG. 1 is a perspective view showing an electric circuit chip according to a first embodiment of the invention.
FIG. 2 is a perspective view showing the electric circuit chip according to the same embodiment.
FIG. 3 is a perspective view showing the electric circuit chip according to the same embodiment.
FIG. 4 is a perspective view showing the electric circuit chip according to the same embodiment.
FIG. 5 is a front view showing an electric circuit chip according to a second embodiment of the invention.
FIG. 6 is a front view showing an example in which a plurality of electric circuit chips according to a third embodiment of the invention is laminated.
FIG. 7 is a front view showing an electric circuit chip according to a fourth embodiment of the invention.
FIG. 8A is a schematic view showing a method of manufacturing the electric circuit chip according to the first embodiment of the invention.
FIG. 8B is a schematic view showing the method of manufacturing the electric circuit chip according to the same embodiment.
FIG. 8C is a schematic view showing the method of manufacturing the electric circuit chip according to the same embodiment.
FIG. 8D is a schematic view showing the method of manufacturing the electric circuit chip according to the same embodiment.
FIG. 8E is a schematic view showing the method of manufacturing the electric circuit chip according to the same embodiment.
FIG. 8F is a schematic view showing the method of manufacturing the electric circuit chip according to the same embodiment.
FIG. 8G is a schematic view showing the method of manufacturing the electric circuit chip according to the same embodiment.
FIG. 9 is a schematic view showing a case in which a circuit in the electric circuit chip according to the same embodiment is formed by filling micropores with a conductor.
FIG. 10 is a schematic view showing a case in which the circuit in the electric circuit chip according to the same embodiment is formed by forming a film of the conductor on micropores.

### EMBODIMENTS FOR CARRYING OUT THE INVENTION

Hereinafter, preferable embodiments of the invention will be described with reference to the accompanying drawings.

### <Electric circuit chip>

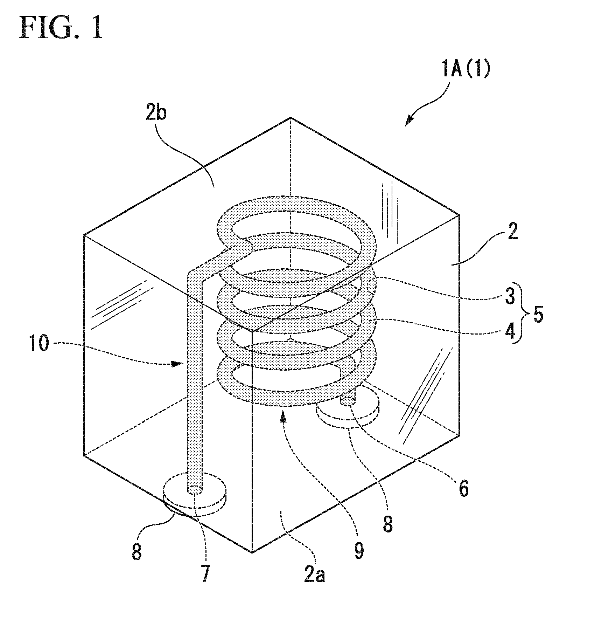

FIG. 1 is a perspective view showing an electric circuit chip 1A (1) in an electric circuit chip-wired circuit board according to a first embodiment of the invention.
The electric circuit chip 1A (1) is an electric circuit chip having a substrate 2 and a circuit 10 disposed in the inside of the substrate 2, in which one end portion (a first end portion) 6 and the other end portion (a second end portion) 7 of the circuit 10 are exposed on a specific surface (a first surface 2a) of the substrate 2.
The circuit 10 includes a spiral inductor 9.
The substrate 2 is made of glass or a semiconductor.

The substrate 2 is a single-layer substrate made of glass such as silica glass or a semiconductor such as silicon.
Here, the "single-layer substrate" refers to a substrate which is differentiated from a multilayer-structured substrate in which a plurality of circuit boards is adhered.

Since the substrate 2 is made of glass or a semiconductor, in a case in which the substrate is mounted in a semiconductor device, the difference in the coefficient of linear expansion is small.
Therefore, when the electric circuit chip 1A (1) and a semiconductor device are connected through soldering or the like, highly accurate connection becomes possible without position deviation.
Glass having insulating properties is particularly preferable as the material of the substrate 2.
In this case, it is possible to fill micropores 3, which are formed in the inside of the substrate, with a conductor 4 or form a film on the inner wall surfaces thereof without forming an insulating layer.
Furthermore, in the circuit 10, there is an advantage that there is no impediment to high-speed transmission caused by the presence of floating capacitance components or the like.
The thickness of the substrate 2 can be appropriately set, and can be set in a range of, for example, 150 µm to 1 mm.

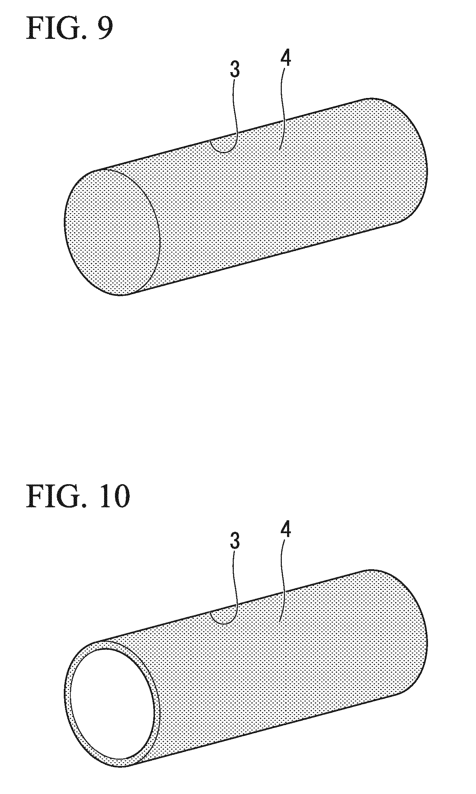

The circuit 10 is formed of the conductor 4 which forms a film or fills the micropores 3 formed in the inside of the substrate 2.
Examples of the conductor 4 that can be used include metals such as Cu (copper), Ag (silver), Au (gold), and A1 (aluminum) and alloys such as a gold-tin (Au-Sn) alloy.
As a method of forming a film of the conductor 4 or filling the micropores 3 with the conductor 4, a molten metal suction method, a plating method, a film-forming method in which a supercritical fluid is used, or the like can be appropriately used.
As shown in FIG. 9, when a molten metal suction method or a plating method is used, it is possible to fill the insides of the micropores 3 with the conductor 4 without space.
In contrast, as shown in FIG. 10, when a plating method or a film-forming method, in which a supercritical fluid is used, is used, it is possible to form the thin film-like conductor 4 along the inner walls of the micropores 3.
In addition, when a material which can fill the micropores 3 or form a film thereon is used as the conductor 4, it is also possible to use a conductive substance which is difficult to use as a wire rod due to the lack of malleability (ductility).

The inductor 9 preferably have a smooth spiral shape which appears to be wrapped around a virtual column (cylinder), elliptical column, or circular ring (torus).
Here, the smooth spiral shape of the inductor which appears to be wrapped around a circular ring refers to the coil shape of a so-called toroidal coil.

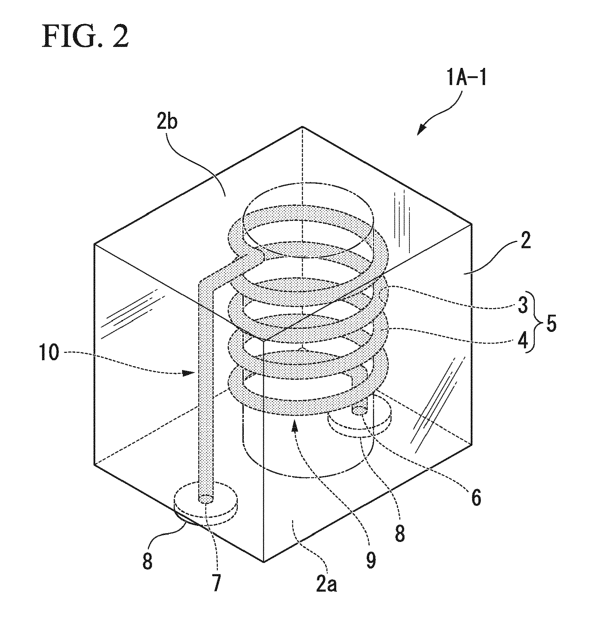

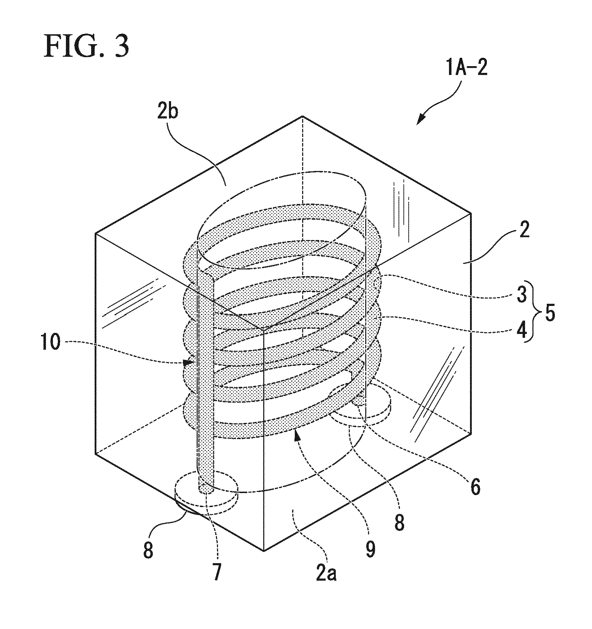

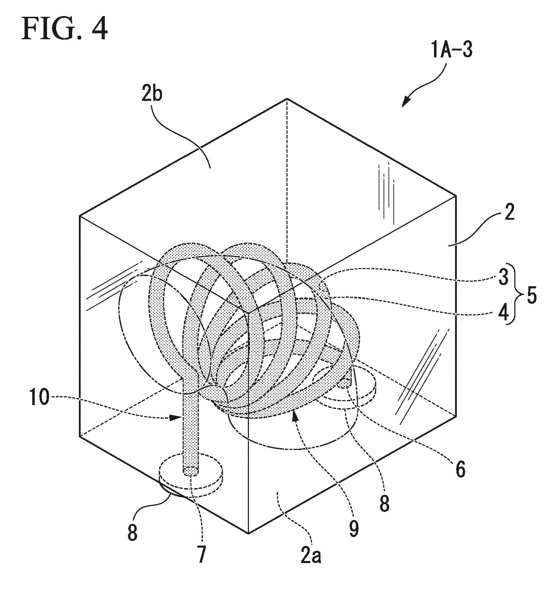

In an electric circuit chip 1A-1 (1) shown in FIG. 2, the conductor 4 that configures the inductor 9 forms a smooth spiral shape which appears to be wrapped around a virtual column (cylinder).
In an electric circuit chip 1A-2 (1) shown in FIG. 3, the conductor 4 that configures the inductor 9 forms a smooth spiral shape which appears to be wrapped around a virtual elliptical column.
In an electric circuit chip 1A-3 (1) shown in FIG. 4, the conductor 4 that configures the inductor 9 forms a smooth spiral shape which appears to be wrapped around a virtual circular ring.

When the inductor 9 is made to have the above smooth spiral shape, it is possible to reduce the transmission loss of high frequencies and the like so as to efficiently generate a magnetic field.
In addition, the inductor 9 is preferably constituted by a seam (joint)-free continuous curve.
In this case, compared to a case in which the inductor is constituted by a discontinuous curve formed by joining a plurality of wires (a partially straight curve), the transmission loss of high frequencies is reduced, and poor joining or peeling caused at seams is prevented.

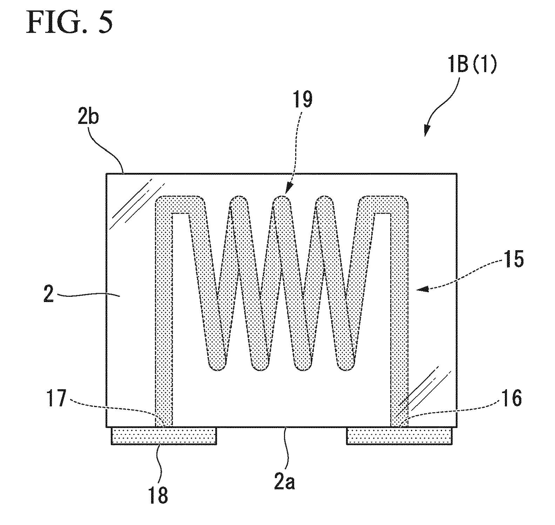

The shape of the circuit 10 or the shape of the inductor 9 (the number of wrapping or the size of the spiral diameter) is not particularly limited, and the circuit and the inductor may be shaped into a desired shape in accordance with the use or the shape of the substrate.
For example, the circuit may have the shape of a circuit 15 in an electric circuit chip 1B (1) according to a second embodiment of the invention which is shown in FIG. 5.

External electrode terminals 8 are preferably provided at one end portion 6 and the other end portion 7 of the circuit 10.
Thereby, it becomes easy to electrically join the electric circuit chip 1A (1) to a mounting circuit board (not shown) or to electrically join the electric circuit chip 1A (1) to other electric circuit chip.
The material of the external electrode terminal 8 is not particularly limited as long as the material is a conductive material, and a metal plate (metal film) made of aluminum or copper, a solder bump, and the like can be applied.

The end portion 6 and the other end portion 7 of the circuit 10 are exposed on a specific surface of the substrate 2.
The end portion 6 and the other end portion 7 are exposed on the same surface, and it is possible to mount the electric circuit chip 1A (1) having the circuit 10 on a flat surface such as a print circuit circuit board or the like.

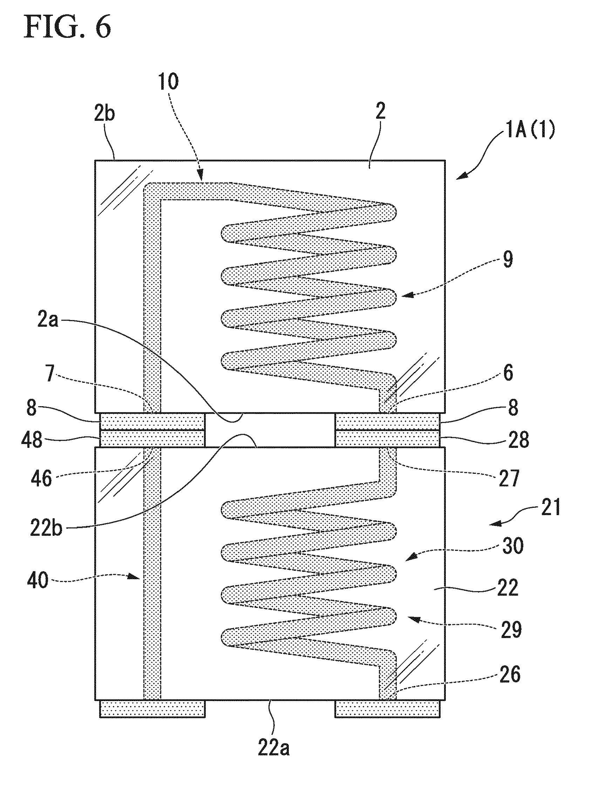

In FIGS. 1 and 5, both the end portions 6 and 16 and the other end portions 7 and 17 are exposed on one surface 2a of the substrate 2, but both end portions do not necessarily need to be exposed on the same surface.
For example, like a second electric circuit chip 21 (a third embodiment) shown in FIG. 6, one end portion (a first end portion) 26 of a circuit 30 may be exposed on one surface (a first surface) 22a of a substrate 22, and the other end portion (a second end portion) 27 of the circuit 30 may be exposed on other surface (a second surface) 22b of the substrate 22.
One surface 22a and the other surface 22b refer to two surfaces located on the mutually opposite sides of the substrate 22.

When the end portion 26 and the other end portion 27 are provided respectively on two surfaces located on the opposite sides of the substrate 22, it becomes possible to laminate and electrically connect a separate electronic device on the second electric circuit chip 21.

FIG. 6 is an example of a composite-type electric circuit chip having the first electric circuit chip 1A (1) laminated on the second electric circuit chip 21.
The external electrode terminal 28 provided at the other end portion 27 of the circuit 30 in the second electric circuit chip 21 and the external electrode terminal 8 provided at the end portion 6 of the circuit 10 in the first electric circuit chip 1 are electrically joined.
Similarly, an external electrode terminal 48 provided at one end portion 46 of a circuit 40 in the second electric circuit chip 21 and the external electrode terminal 8 provided at the other end portion 7 of the circuit 10 in the first electric circuit chip 1 are electrically joined.

In the circuit 30 of the second electric circuit chip 21, an inductor 29 is formed.
The inductor 29 is the same as the inductor 9 formed in the circuit 10 of the first electric circuit chip 1.

In the composite-type electric circuit chip, the inductor 29 in the second electric circuit chip 21 and the inductor 9 in the first electric circuit chip 1 are disposed in series and function in conjunction with each other.
That is, since magnetic fields generated by both inductors mutually influence each other, and function in conjunction, it is possible to consider both as a single inductor.

The inductors 9, 19, and 29 formed in the electric circuit chips 1A, 1B, and 21 exemplified in FIGS. 1, 5, and 6 are all drawn as air core inductors.
However, it is also possible to use core inductors as the inductors.
It is possible to produce a core inductor by disposing a magnetic body such as ferrite in cavities provided in an area that forms the core in the substrate.

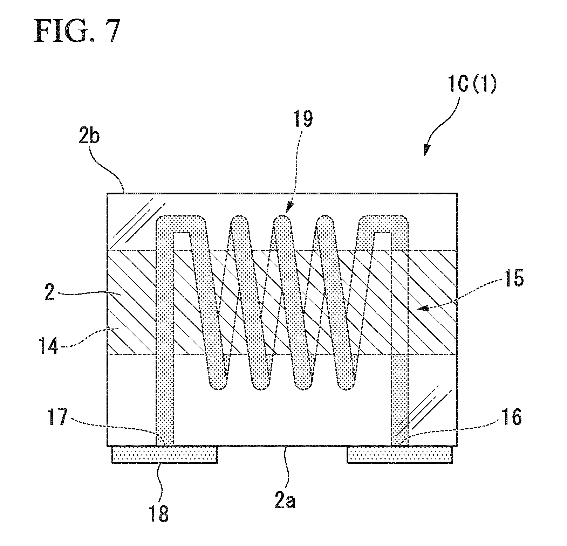

Examples thereof include an electric circuit chip 1C (1) which is a fourth embodiment shown in FIG. 7.
In the electric circuit chip 1C (1), the same configurations as in the electric circuit chip 1B (1) will be given the same reference numerals.
The electric circuit chip 1C (1) has a core 14 made of a magnetic body at the core region of the inductor 19.
The material of the magnetic body is not particularly limited as long as the material is ordinarily used in core coils, and examples thereof include iron oxide, Mn, Co, Ni, Cu, Zn, and the like.
Examples of the shape of the core 14 include a rod shape, an E letter form, a drum form, and the like.
Among the above, the rod shape is preferable from the viewpoint of easy manufacturing.
In a case in which the core has a rod shape (columnar form), the diameter needs to be set to 0.2 to 0.9 with respect to the inner diameter (= 1) of the inductor.

### <Method of manufacturing an electric circuit chip>

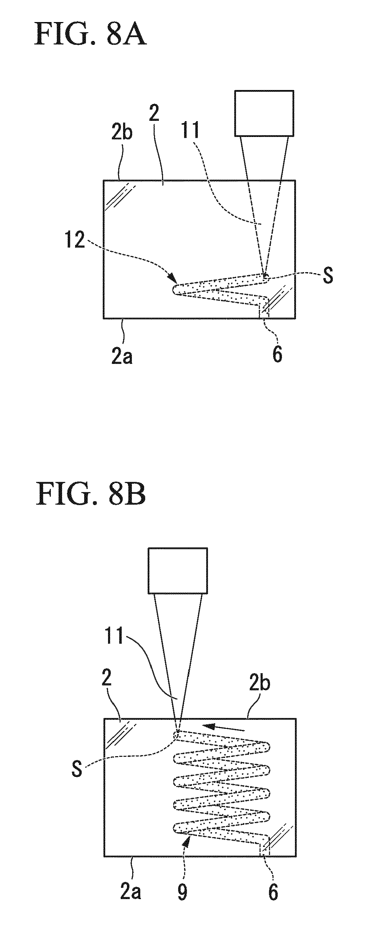

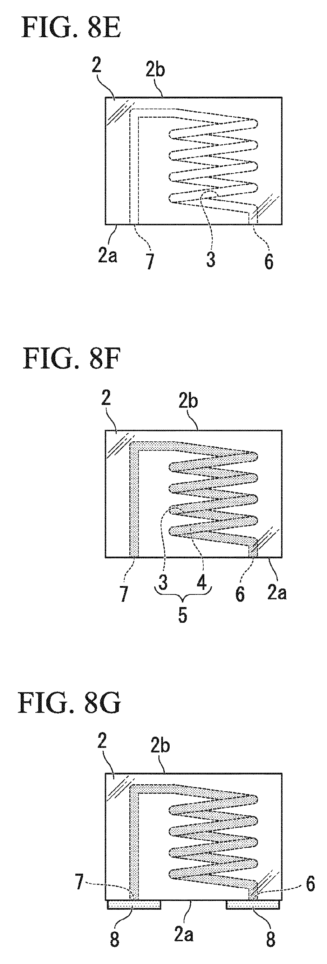

Next, a method of manufacturing the electric circuit chip 1A (1) will be shown in FIGS. 8A to 8G as a method of manufacturing the electric circuit chip according to the first embodiment of the invention.
Here, FIGS. 8A to 8G are front views of the substrate 2 which is used to manufacture the electric circuit chip 1A (1).

### [Process A]

Firstly, as shown in FIG. 8A, the substrate 2 made of glass or a semiconductor is irradiated with laser light 11 so as to form modified regions 12 obtained by modifying the glass or semiconductor in the substrate 2.
The modified regions 12 are formed in areas in which the circuit 10 is disposed.

The material of the substrate 2 is preferably a glass circuit board or a semiconductor circuit board such as a silicon.
In a case in which the above circuit board is used, the following method is preferable from the viewpoint of manufacturing efficiency. That is, a glass circuit board or a semiconductor circuit board having a plurality of circuits 10 is obtained by, for example, forming a plurality of modified regions 12 in a glass circuit board or a semiconductor circuit board having a diameter of 300 mm.
After that, individual electric circuit chips are cut out from the circuit board through dicing or the like.

The laser light 11 is irradiated from the other surface (the second surface) 2b side of the substrate 2, and converges at a focal point S in the substrate 2.
The material of the substrate 2 is modified at the location at which the focal point S converges.
The focal point S is sequentially scanned from a location which forms the end portion 6 of the circuit 10 to an area which forms the inductor 9 so as to form a modified region 12 (FIGS. 8A and 8B).

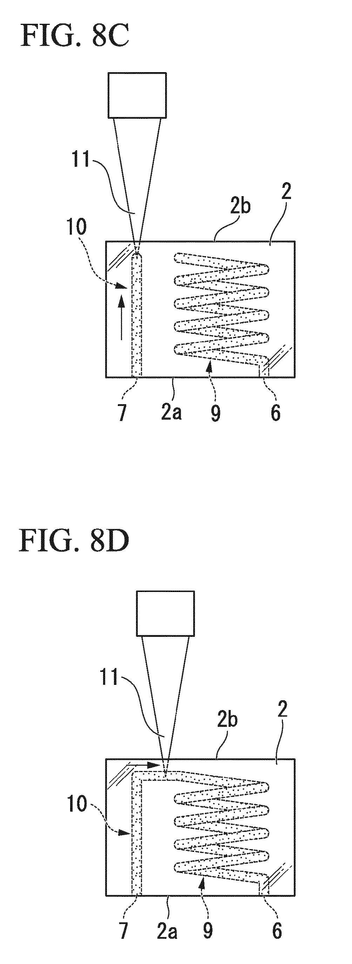

Subsequently, the focal point S is scanned from a location which forms the other end portion 7 of the circuit 10 toward the other surface 2b of the substrate 2.
Next, the focal point S is scanned in parallel with the other surface 2b of the substrate 2 so as to form a modified region 12 which is smoothly coupled with the previously formed modified region 12 so that there is no seam (FIGS. 8C and 8D).
Thereby, the modified region 12 is formed at the entire area which forms the circuit 10.

Examples of a light source of the laser light 11 include femtosecond laser.
It is possible to form the modified region 12 having a diameter of, for example, several µm to several tens of µm by irradiating the substrate with the laser light 11.
In addition, it is possible to form the modified region 12 having a desired shape by controlling the location at which the focal point S of the laser light 11 is pointed in the inside of the substrate 2.

Herein, a case in which the laser light 11 is irradiated from the other surface 2b side of the substrate 2 has been shown, but the laser light may be irradiated from a different surface.
However, in general, since the transmittance of a laser at a modified portion is different from the transmittance of a laser at an unmodified portion, normally, it is difficult to control the focal point of laser light which has transmitted the modified portion.
Therefore, it is desirable to form a modified region in advance at an area located on the inside of a surface from which laser is irradiated.

### [Process B]

The modified regions 12 are removed from the substrate 2, by immersing the substrate 2 in which the modified regions 12 are formed in an etchant (chemical) so as to carry out wet etching.
As a result, the micropores 3 are formed in the area in which the modified regions 12 have been present (FIG. 8E).
In the embodiment, glass was used as the material of the substrate 2, and a solution mainly including a 10 mass% solution of hydrogen fluoride (HF) was used as the etchant.

The etching uses a phenomenon in which the modified regions 12 are etched in a significantly rapid manner compared to the unmodified portions of the substrate 2.
As a result, it is possible to form the micropores 3 in accordance with the shape of the modified regions 12.
The etchant is not particularly limited, and examples of the etching that can be used include a solution mainly including hydrogen fluoride (HF), fluonitric acid-based mixed acids obtained by adding an appropriate amount of nitric acid or the like to hydrogen fluoride, and the like.
In addition, it is also possible to use other chemicals depending on the material of the substrate 2.

### [Process C]

In the substrate 2 in which the micropores 3 are formed, the circuit 10 is formed by filling the micropores 3 with the conductor (conductive substance) 4 or forming a film of the conductor 4 thereon.
Examples of the conductor 4 include gold-tin (Au-Sn), copper (Cu), and the like.
As a method of filling the micropores with the conductor 4 or forming a film of the conductor, it is possible to appropriately use a molten metal suction method, a plating method, or the like.
As shown in FIG. 9, when a molten metal filling method or a plating method is used, it is possible to fill the insides of the micropores 3 with the conductor 4 without void.
In Contrast, as shown in FIG. 10, when a plating method or a film-forming method, in which a supercritical fluid is used, is used, it is possible to form the thin film-like conductor 4 along the inner walls of the micropores 3.

The electric circuit chip 1 shown in FIG. 1 is obtained through the above processes A to C.
Furthermore, if desired, the external electrode terminals 8 may be formed on the end portion 6 and the other end portion 7.
As a method of forming the external electrode terminals 8, it is possible to appropriately use a plating method, a sputtering method, or the like.

In addition, an electric circuit chip having the core 14 like the electric circuit chip 1C (1) shown in FIG. 7 is manufactured using the following method.
For example, the modified regions are formed in an area which forms the core 14 of the substrate 2 in Process A, subsequently, the modified regions are removed through etching in Process B, and a magnetic body is introduced into the formed through holes.
According to the above method, it is possible to form the through holes of a desired shape, such as a partially-cut column, elliptical column, or circular ring shape and include the core 14.
In addition, the through holes can be formed in the substrate 2 using a method in which a micro drill is used, a method in which a resist mask is provided on the surface of the substrate 2 and etching is carried out, or the like.
Examples of a method of introducing a magnetic body into the formed through holes in the substrate 2 include a method in which a rod-shaped magnetic body is fitted, a method in which a film of a magnetic body is formed or a magnetic body is made to fill the through holes using a sputtering method or a plating method, a method in which a resin paste including a magnetic body is made to fill the through holes using a printing method, or the like.

In a case in which the core 14 is provided in the substrate 2, the circuit 10 may be formed in advance, or the core 14 may be formed in advance.

### INDUSTRIAL APPLICABILITY

It is possible to widely use the electric circuit chip 1 and the method of manufacturing the electric circuit chip 1 according to some embodiment of the invention for manufacturing ICs or electronic components.

### DESCRIPTION OF THE REFERENCE SYMBOLS

| | |
|---|---|
| 1, 1A, 1A-1, 1A-2, 1A-3, 1B | ELECTRIC CIRCUIT CHIP (FIRST ELECTRIC CIRCUIT CHIP) |
| 2 | SUBSTRATE |
| 2a | ONE SURFACE OF SUBSTRATE (FIRST SURFACE) |
| 2b | OTHER SURFACE OF SUBSTRATE (SECOND SURFACE) |
| 3 | MICROPORE |
| 4 | CONDUCTOR |
| 5 | CIRCUIT WIRE |
| 6 | ONE END PORTION (FIRST END PORTION) |
| 7 | OTHER END PORTION (SECOND END PORTION) |
| 8 | EXTERNAL ELECTRODE TERMINAL |
| 9 | INDUCTOR |
| 10 | CIRCUIT |
| 11 | LASER LIGHT |
| 12 | MODIFIED REGION |
| 14 | CORE |
| 15 | CIRCUIT |
| 16 | ONE END PORTION (FIRST END PORTION) |
| 17 | OTHER END PORTION (SECOND END PORTION) |
| 18 | EXTERNAL ELECTRODE TERMINAL |
| 19 | INDUCTOR |
| S | FOCAL POINT |
| 21 | SECOND ELECTRIC CIRCUIT CHIP |
| 22 | SUBSTRATE |
| 22a | ONE SURFACE OF SUBSTRATE (FIRST SURFACE) |
| 22b | OTHER SURFACE OF SUBSTRATE (SECOND SURFACE) |
| 26 | ONE END PORTION (FIRST END PORTION) |
| 27 | OTHER END PORTION (SECOND END PORTION) |
| 28 | EXTERNAL ELECTRODE TERMINAL |
| 29 | INDUCTOR |
| 30 | CIRCUIT |
| 40 | CIRCUIT |
| 46 | ONE END PORTION (FIRST END PORTION) |
| 47 | OTHER END PORTION (SECOND END PORTION) |
| 48 | EXTERNAL ELECTRODE TERMINAL |

## Claims

1. An electric circuit chip comprising:
a substrate made of glass or a semiconductor; and
a circuit which is disposed in an inside of the substrate, has a first end portion and a second end portion exposed at specific surfaces of the substrate, and comprises a spiral inductor.

2. The electric circuit chip according to Claim 1,
wherein external electrode terminals are provided at the first end portion and the second end portion.

3. The electric circuit chip according to Claim 1 or 2,
wherein the inductor has a spiral shape that follows a virtual column, elliptical column, or circular ring.

4. The electric circuit chip according to any one of Claims 1 to 3,
wherein the inductor is constituted by a continuous curve.

5. The electric circuit chip according to any one of Claims 1 to 4,
wherein a core made of a magnetic body is provided in a space surrounded by the inductor.

6. The electric circuit chip according to any one of Claims 1 to 5,
wherein the first end portion and the second end portion are provided on the same surface of the substrate.

7. The electric circuit chip according to any one of Claims 1 to 5,
wherein the substrate has a first surface and a second surface which is located on an opposite side of the first surface,
the first end portion is provided on the first surface, and
the second end portion is provided on the second surface.

8. A method of manufacturing an electric circuit chip comprising:
irradiating an inside of a substrate made of glass or a semiconductor with laser light and scanning a focal point at which the laser light is collected, thereby forming spiral modified regions;
carrying out an etching treatment on the substrate in which the modified regions are formed and removing the modified regions, thereby forming spiral micropores; and
filling the micropores with a conductor or forming a film.

9. The method of manufacturing an electric circuit chip according to Claim 8,
wherein, when the modified regions are formed, the modified regions are formed in an area in which a core is formed.
